# FASCICULE DE BREVET EUROPEEN

(11) **EP 2 126 969 B1**
(45) Date de publication et mention de la délivrance du brevet: **27.06.2012**
(21) Numéro de dépôt: 08708288.9
(22) Date de dépôt: 28.01.2008
(51) Int. Cl.: H01L 21/60, H01L 23/48, H01L 25/065, H01L 21/98

(54) **PROCEDE D'INTERCONNEXION DE TRANCHES ELECTRONIQUES**
VERFAHREN ZUR VERBINDUNG ELEKTRONISCHER WAFER
METHOD OF INTERCONNECTING ELECTRONIC WAFERS

(30) Priorité: 30.01.2007 FR 0700625
(43) Date de publication de la demande: 02.12.2009
(73) Titulaire: 3D Plus, 78532 Buc Cedex (FR)
(72) Inventeur: VAL, Christian, F-78470 St Remy Les Chevreuse (FR)
(74) Mandataire: Henriot, Marie-Pierre
(86) Numéro de dépôt international: PCT/EP2008/050970
(87) Numéro de publication internationale: WO 2008/095811

(56) Documents cités:
- EP-A- 0 283 003
- EP-A- 1 452 326
- US-A1- 2003 079 680
- US-A1- 2004 092 099
- US-A1- 2004 188 819
- US-A1- 2005 098 775
- US-A1- 2005 104 181

## Description

Le domaine de l'invention est celui de l'interconnexion de modules électroniques 3D et plus précisément de l'interconnexion verticale.

Un module électronique 3D est un empilement de composants électroniques hétérogènes. Par composant hétérogène on entend un composant électronique comprenant à la fois un ou plusieurs composants actif(s) et/ou passif(s) connectés ensemble et formant ainsi un circuit électronique qui assure une fonction électronique donnée. Le composant actif comprend tout composant couramment appelé « puce » et mettant en oeuvre la technologie des semi-conducteurs ; il s'agit par exemple d'une diode, d'un transistor, d'un circuit intégré, d'un circuit dédié ASIC, d'une mémoire ou d'un microprocesseur. Par composant passif on entend les autres composants, qu'il s'agisse de composants classiques de type résistance, condensateur ou inductances montés en surface ou encore les composants électromécaniques gravés dans le silicium et connus sous le nom de MEMS, acronyme de l'expression anglo-saxonne « Micro Electro Mechanical Systems ».

Par interconnexion verticale, on entend interconnexion dans le sens de l'empilement.

L'interconnexion de modules électroniques 3D est réalisé selon de nombreuses techniques que l'on peut découper en deux familles :
- l'interconnexion et empilage de composants hétérogènes,
- l'interconnexion et l'empilage de tranches de silicium (« wafers ») qui comportent chacune une multitude de composants hétérogènes identiques.

Un exemple de procédé d'interconnexion verticale d'un empilement de dispositifs semi-conducteurs est décrit dans le le document US 2004/092099.

L'invention concerne l'interconnexion verticale de ces tranches.

Selon une technique connue, ces tranches sont interconnectées au moyen de vias c'est-à-dire de trous traversant la tranche dans son épaisseur, isolés électriquement de celle-ci puis métallisés. Les composants sont connectés aux vias. L'interconnexion de vias métallisés est délicate ; elle est basée sur des procédés de :
- thermocompression
- refusion d'alliage de brasage,

Ces procédés nécessitent en général :
- des traitements haute température et/ou une pression sur chaque interconnexion qui détériorent un taux non négligeable de composants,
- des alignements extrêmement précis difficiles à obtenir,
- une très bonne planéité car tous les vias doivent être en contact.

En outre, les modules 3D obtenus sont individuellement contrôlés mais la qualité de l'interconnexion ne l'est pas.

Le but de l'invention est de pallier ces inconvénients.

L'invention est basée sur l'interconnexion par frittage de nanoparticules d'argent, de cuivre ou d'or présentes dans une encre déposée sur des vias.

Plus précisément l'invention a pour objet le procédé selon la revendication 1, ce procédé étant un procédé d'interconnexion de composants électroniques d'une première tranche avec des composants électroniques d'une deuxième tranche, chaque tranche comportant des vias métallisés qui traversent la tranche dans l'épaisseur, caractérisé en ce qu'il comprend les étapes suivantes de :
- dépôt d'une goutte d'encre conductrice comprenant des solvants et des nanoparticules de métal, le métal étant de l'argent, du cuivre ou de l'or, sur chaque via de la première tranche,
- empilage de la deuxième tranche sur la première de manière à ce que les vias de la deuxième tranche soient sensiblement superposés sur les vias de la première tranche,
- élimination de 50 à 90% des solvants contenus dans les gouttes par chauffage ou dépression de façon à obtenir une encre pâteuse,
- frittage des gouttes d'encre pâteuse par laser afin de réaliser des connexions électriques entre les vias métallisés superposés.

Selon une caractéristique de l'invention, il comprend une étape supplémentaire de contrôle d'au moins une connexion électrique au moyen d'une diode intégrée au laser.

La première tranche est éventuellement une tranche préalablement connectée à au moins une autre tranche.

L'encre conductrice comprend des nanoparticules de Ag ou Cu ou Au.

D'autres caractéristiques et avantages de l'invention apparaîtront à la lecture de la description détaillée qui suit, faite à titre d'exemple non limitatif et en référence aux dessins annexés dans lesquels :
les figures 1 représentent schématiquement des vues en coupe de différents modes de réalisation de vias,
les figures 2 et 2' illustrent schématiquement des vues en coupe de différentes étapes du procédé d'interconnexion selon l'invention,
les figures 3 et 3' illustrent une vue en coupe d'une des étapes d'interconnexion d'un empilement de 3 tranches selon l'invention.
D'une figure à l'autre, les mêmes éléments sont repérés par les mêmes références.

L'invention concerne l'interconnexion verticale de tranches munies de vias métallisés et qui comportent chacune une multitude de composants hétérogènes identiques électriquement reliés entre eux et/ou à ces vias. Une tranche a typiquement une épaisseur de 10 à 200 µ.

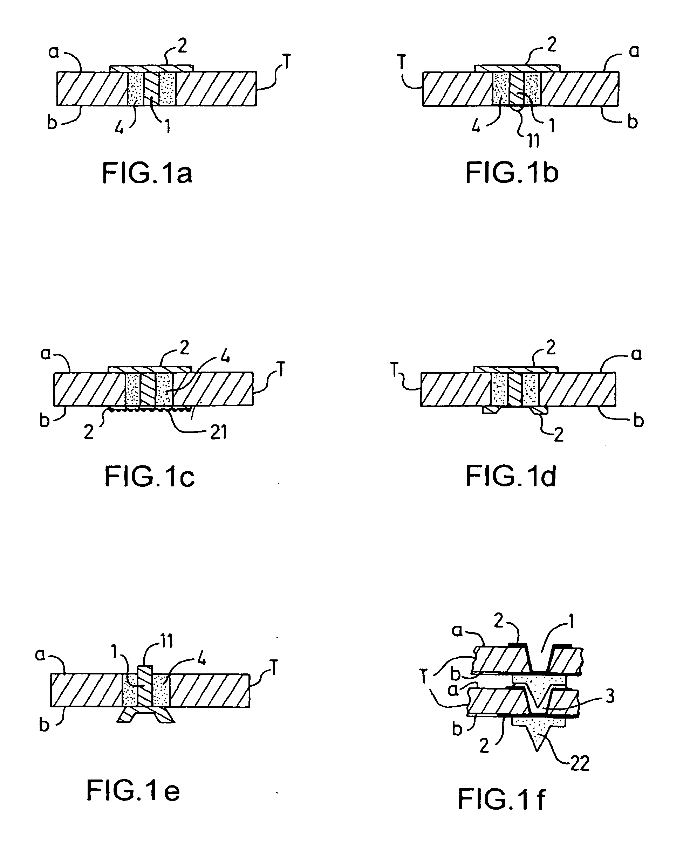

Plusieurs modes de réalisation des vias sont envisagés : ils sont décrits en relation avec les figures 1. Le métal des vias est par exemple du cuivre ou de l'or ; il peut seulement recouvrir les parois des vias ou les remplir et former un pilier. Un via a typiquement un diamètre de 2 à 50 µ. Chaque via 1 est isolé de la tranche T de silicium par un isolant électrique 4 tel que du SiO₂ comme le montre la figure 1a. Une protubérance 11 peut être réalisée sur une extrémité d'un pilier 1 (cf figure 1b) ; la croissance d'un bossage protubérant électriquement conducteur peut aussi être effectuée sur un pilier. Selon un mode de réalisation, une collerette 2 électriquement conductrice par exemple en cuivre, entoure le via 1 sur l'une et/ou l'autre face (a, b) de la tranche T. Eventuellement la collerette 2 forme une pastille pleine sensiblement centrée sur le via : ces deux formes de collerettes sont illustrées figure 1d, la collerette formant pastille étant disposée sur la face a. La collerette 2 peut être munie de micro bossages 21 ou d'un gros bossage 22 électriquement conducteurs par exemple en or, respectivement représentés figure 1c et 1f.

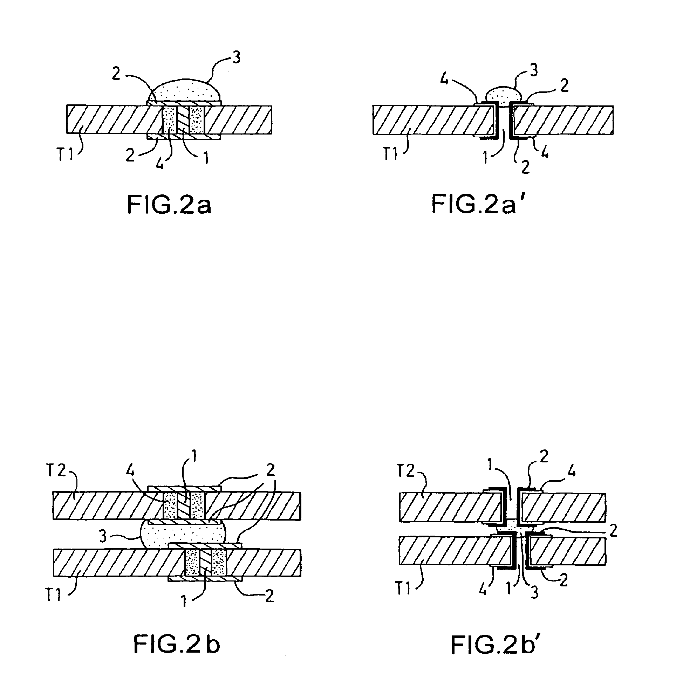

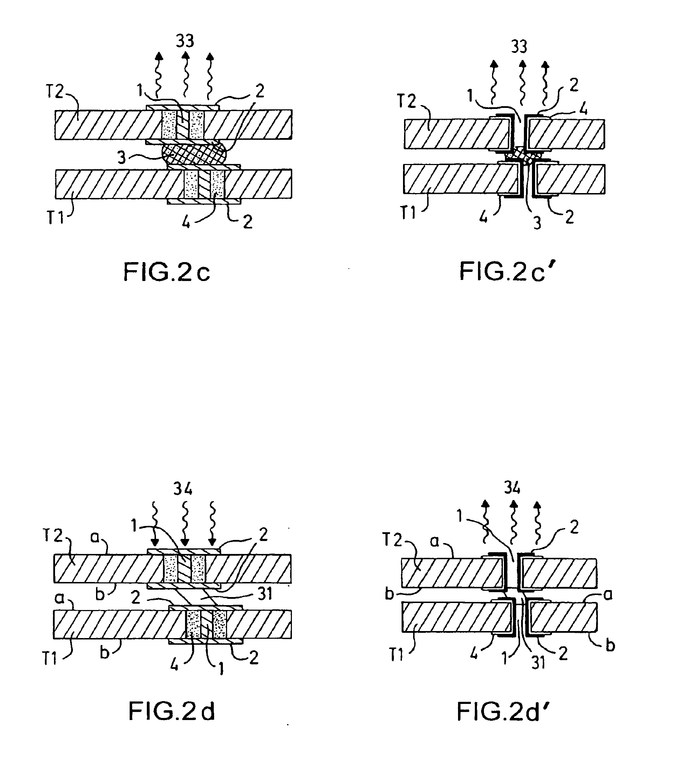

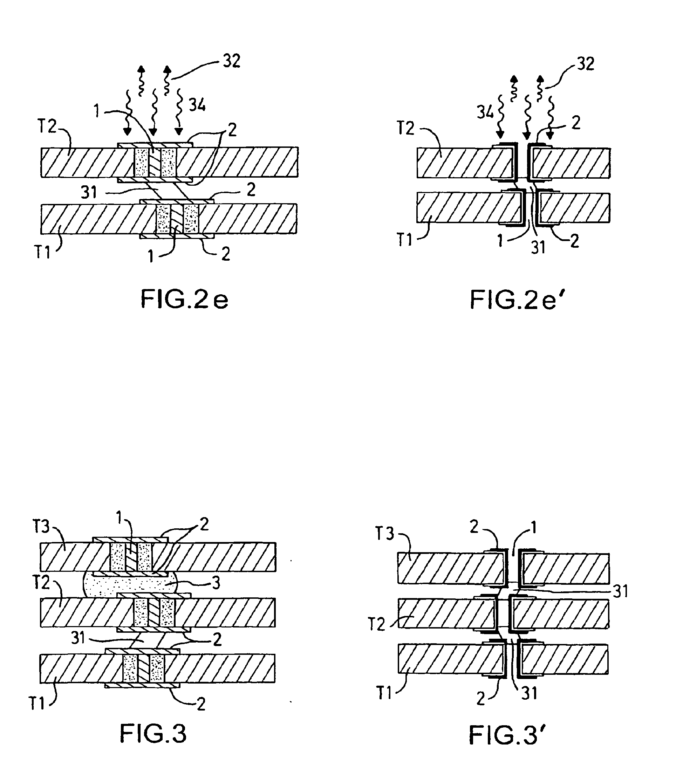

On va à présent décrire les différentes étapes du procédé selon l'invention en relation avec les figures 2 ou 2'. Les vias 1 représentés sur les figures 2 et 3 sont des piliers, et des pastilles 2 sont disposées sur les vias sur les deux faces a et b de chaque tranche ; sur les figures 2' et 3', le métal des vias 1 ne recouvrent que les parois et des collerettes 2 sont disposées autour de ces vias sur les deux faces a et b de chaque tranche .

Une goutte 3 d'encre conductrice d'épaisseur comprise entre 1 et 20 µ est déposée sur chaque via 1 d'une première tranche T1, cette goutte étant centrée par l'éventuelle collerette ou recouvrant sensiblement celle-ci lorsqu'il s'agit d'une pastille comme illustré figures 2a' et 2a. Les bossages ou protubérance éventuels 11, 21, 22 représentés figures 1, visent à renforcer les points de contact avec la goutte 3 d'encre. La protubérance 11 du pilier ou le bossage protubérant 22 sont en outre destinés à s'emboîter dans la cavité délimitée par la collerette 2, respectivement dans un via 1 creux adapté à la géométrie du bossage comme illustré figure 1f. Cette encre comprend des nanoparticules de métal noyées dans un solvant ; ce métal est typiquement de l'argent, du cuivre ou de l'or. Ces gouttes 3 sont par exemple déposées par jet d'encre au moyen d'une buse selon un procédé de goutte à la demande ou par sérigraphie ; il s'agit d'un dépôt localisé sur les vias ou leurs collerettes.

Une deuxième tranche T2 est empilée sur la première de façon à ce que les vias 1 de la deuxième tranche soient parfaitement ou quasiment superposés à ceux de la première : ceci est visible sur les figures 2b et 2b'. Ce faisant la goutte d'encre 3 peut se trouver légèrement décalée de sa position d'origine.

Les solvants contenus dans la goutte d'encre sont partiellement éliminés par chauffage dans un four à une température inférieure à 100 °C ou sous vide en créant une dépression comprise entre 100 à 200 mbars. Cette élimination des solvants illustrée par les flèches 33 figures 2c et 2c' vise à en éliminer de 50 à 90% de manière à obtenir une encre pâteuse.

On se reportera aux figures 2d et 2d' pour l'étape suivante de frittage des gouttes conductrices 3, obtenue par apport d'énergie 34. Le frittage est la consolidation d'un matériau, obtenue par apport d'énergie, sans aller jusqu'à la fusion. En l'occurrence, le matériau est cette encre qui comprend des nanoparticules d'argent. Sous l'effet de cette énergie, les nanoparticules se soudent entre elles et forment ainsi une liaison mécanique et électrique. Cet apport d'énergie 34 est de préférence un apport d'énergie localisé au niveau des vias 1, que l'on obtient par exemple au moyen d'un laser à impulsions, tel qu'un laser YAG ou CO₂ émettant des impulsions d'une durée de l'ordre de quelques ns à une fréquence de répétition comprise entre 1 à 50 kHz. On peut aussi réaliser un chauffage global des gouttes en plaçant les tranches empilées dans une atmosphère réductrice ou non-oxydante comportant typiquement du « forming gaz » qui est un mélange d'hydrogène et d'azote.

La chaleur 34 qui est principalement dirigée sur la face a supérieure de la tranche T2, va diffuser dans le piller central métallisé du via 1 qui canalise cette chaleur et la conduit sur la pastille 2 de la face b inférieure de la tranche T2. Cette pastille 2 qui est en contact avec la goutte d'encre 3 conduit la chaleur vers cette goutte qui est également en contact (éventuellement en contact partiel) avec la pastille 2 de la face a supérieure de la première tranche T1 ; la chaleur permet de fritter les particules d'argent entre la pastille 2 inférieure de la deuxième tranche T2 et la pastille 2 supérieure de la première tranche T1, même si ces pastilles ne sont pas parfaitement superposées comme illustré sur ces figures. Une liaison électrique 31 est ainsi réalisée entre les vias 1 des première et deuxième tranches T1, T2.

Bien que cette étape ne soit pas indispensable, on procède de préférence à une étape de contrôle de la liaison 31 entre les deux tranches T1, T2 (cf figures 2e et 2e') : elle est avantageusement effectuée par analyse de la signature thermique de cette liaison. En effet la transmission thermique entre la pastille 2 supérieure (face a) de la première tranche T1 et la pastille 2 inférieure (face b) de la deuxième tranche T2, et donc la signature est totalement différente selon que la liaison existe ou pas. Cette signature est avantageusement analysée par le laser utilisé pour le frittage celui-ci étant alors équipé d'une diode permettant d'analyser le signal 32 retourné par la pastille 2 de la tranche supérieure T2.

Après avoir empilé et connecté deux tranches T1, T2, on peut réitérer le procédé pour connecter une troisième tranche T3 sur la tranche supérieure T2 de l'empilement déjà connecté ; et ainsi de suite pour obtenir un empilement de n tranches, n>3. L'étape d'empilement de la tranche T3 après dépôt de gouttes d'encre sur la tranche T2, correspondant à l'étape de la figure 2b est représentée figure 3 et l'empilement des 3 tranches connectées selon le procédé est représentée figure 3'. Selon une variante, k tranches (k>2) sur lesquelles des gouttes d'encre ont été déposées sont empilées. Les étapes d'évaporation partielle des solvants, de frittage des gouttes et éventuellement de contrôle des liaisons sont alors appliquées à l'empilement.

## Revendications

1. Procédé d'interconnexion de composants électroniques d'une première tranche (T1) avec des composants électroniques d'une deuxième tranche (T2), chaque tranche comportant des vias (1) métallisés qui traversent la tranche dans l'épaisseur, **caractérisé en ce qu'**il comprend les étapes suivantes de :
- dépôt d'une goutte (3) d'encre conductrice comprenant des solvants et des nanoparticules de métal, le métal étant de l'argent, du cuivre ou de l'or, sur chaque via (1) de la première tranche (T1),
- empilage de la deuxième tranche (T2) sur la première de manière à ce que les vias (1) de la deuxième tranche (T2) soient sensiblement superposés sur les vias (1) de la première tranche (T1),
- élimination de 50 à 90% des solvants contenus dans les gouttes (3) par chauffage ou dépression de façon à obtenir une encre pâteuse,
- frittage des gouttes (3) d'encre pâteuse par laser afin de réaliser des connexions (31) électriques entre les vias (1) métallisés superposés.

2. Procédé selon la revendication précédente, **caractérisé en ce qu'**il comprend une étape supplémentaire de contrôle d'au moins une connexion (31) électrique au moyen d'une diode intégrée au laser.

3. Procédé selon l'une des revendications précédentes, **caractérisé en ce que** la première tranche (T1) est une tranche préalablement connectée à au moins une autre tranche.

4. Procédé selon l'une des revendications précédentes, **caractérisé en ce que** les gouttes (3) sont déposées par jet d'encre ou par sérigraphie.

5. Procédé selon l'une des revendications précédentes, **caractérisé en ce que** le métal des vias métallisés remplit les vias et forme ainsi des piliers.

6. Procédé selon la revendication précédente, **caractérisé en ce qu'**un pilier est prolongé par une protubérance (11).

7. Procédé selon l'une des revendications précédentes, **caractérisé en ce qu'**une tranche présentant deux faces (a, b), une collerette (2) électriquement conductrice entoure un via (1) métallisé sur l'une et/ou l'autre face d'une tranche et **en ce qu'**une goutte (3) déposée sur le via (1) est en contact avec cette collerette (2).

8. Procédé selon la revendication 7, **caractérisé en ce que** la collerette (2) forme une pastille pleine sensiblement centrée sur le via (1).

9. Procédé selon l'une des revendications 7 ou 8, caractérisé en ce 20 qu'au moins une collerette (2) est munie de bossages (21).

## Claims

1. A method for interconnecting electronic components of a first wafer (T1) with electronic components of a second wafer (T2), each wafer comprising metallised vias (1) that pass through the thickness of the wafer, **characterised in that** it comprises the following steps of:
- depositing a droplet (3) of conductive ink that contains solvents and metal nanoparticles, which metal is silver, copper or gold, on each via (1) of said first wafer (T1),
- stacking the second wafer (T2) onto the first wafer so that the vias (1) of the second wafer (T2) are substantially superposed on the vias (1) of said first wafer (T1),
- removing 50 to 90% of the solvents contained in the droplets (3) by heating or by vacuum so as to obtain a pasty ink,
- laser sintering the droplets (3) of pasty ink so as to produce electrical connections (31) between the superposed metallised vias (1).

2. The method according to the preceding claim, **characterised in that** it comprises a further step of checking at least one electrical connection (31) by means of a diode integrated into the laser.

3. The method according to any one of the preceding claims, **characterised in that** the first wafer (T1) is a wafer that has previously been connected to at least one other wafer.

4. The method according to any one of the preceding claims, **characterised in that** the droplets (3) are deposited by an inkjet or by screen printing.

5. The method according to any one of the preceding claims, **characterised in that** the metal of the metallised vias fills the vias and thus forms posts.

6. The method according to the preceding claim, **characterised in that** a post is extended by a protuberance (11).

7. The method according to any one of the preceding claims, **characterised in that** with the wafer having two surfaces (a, b), an electrically conductive flange (2) surrounds a metallised via (1) on the one and/or on the other surface of a wafer, and **in that** a droplet (3) that is deposited on the via (1) is in contact with said flange (2).

8. The method according to claim 7, **characterised in that** the flange (2) forms a continuous chip that is substantially centred on the via (1).

9. The method according to claim 7 or 8, **characterised in that** at least one flange (2) is provided with bosses (21).

## Patentansprüche

1. Verfahren zum Verbinden von elektronischen Komponenten eines ersten Wafers (T1) mit elektronischen Komponenten eines zweiten Wafers (T2), wobei jeder Wafer metallisierte Durchkontaktierungen (1) aufweist, die den Wafer in seiner Dicke durchdringen, **dadurch gekennzeichnet, dass** es die folgenden Schritte beinhaltet:
- Absetzen eines Tröpfchens (3) leitender Tinte, die Lösungsmittel und Metall-Nanopartikel enthält, wobei das Metall Silber, Kupfer oder Gold ist, auf jede Durchkontaktierung (1) des ersten Wafers (T1),
- Stapeln des zweiten Wafers (T2) auf den ersten Wafer so, dass die Durchkontaktierungen (1) des zweiten Wafers (T2) im Wesentlichen über den Durchkontaktierungen (1) des ersten Wafers (T1) liegen,
- Entfernen von 50 bis 90% der in den Tröpfchen (3) enthaltenen Lösungsmittel durch Erhitzen oder mit Unterdruck, um eine pastenartige Tinte zu erhalten;
- Lasersintern der pastenartigen Tintentröpfchen (3), um elektrische Verbindungen (31) zwischen den übereinander liegenden metallisierten Durchkontaktierungen (1) zu erzeugen.

2. Verfahren nach dem vorherigen Anspruch, **dadurch gekennzeichnet, dass** es einen weiteren Schritt des Prüfens von wenigstens einer elektrischen Verbindung (31) mittels einer im Laser integrierten Diode beinhaltet.

3. Verfahren nach einem der vorherigen Ansprüche, **dadurch gekennzeichnet, dass** der erste Wafer (T1) ein Wafer ist, der zuvor mit wenigstens einem anderen Wafer verbunden wurde.

4. Verfahren nach einem der vorherigen Ansprüche, **dadurch gekennzeichnet, dass** die Tröpfchen (3) durch einen Tintenstrahl oder durch Siebdruck abgesetzt werden.

5. Verfahren nach einem der vorherigen Ansprüche, **dadurch gekennzeichnet, dass** das Metall der metallisierten Durchkontaktierungen diese füllt und so Pfosten bildet.

6. Verfahren nach dem vorherigen Anspruch, **dadurch gekennzeichnet, dass** ein Pfosten durch einen Vorsprung (11) verlängert wird.

7. Verfahren nach einem der vorherigen Ansprüche, **dadurch gekennzeichnet, dass**, wenn ein Wafer zwei Seiten (a, b) hat, ein elektrisch leitender Flansch (2) eine metallisierte Durchkontaktierung (1) auf der einen und/oder der anderen Seite eines Wafers umgibt, und dadurch, dass ein auf die Durchkontaktierung (1) abgesetztes Tröpfchen (3) mit dem Flansch (2) in Kontakt ist.

8. Verfahren nach Anspruch 7, **dadurch gekennzeichnet, dass** der Flansch (2) eine durchgehende Scheibe bildet, die im Wesentlichen auf der Durchkontaktierung (1) zentriert ist.

9. Verfahren nach Anspruch 7 oder 8, **dadurch gekennzeichnet, dass** wenigstens ein Flansch (2) mit Erhebungen (21) versehen ist.
